**Europäisches Patentamt**

(19) **European Patent Office**

**Office européen des brevets**

(11) Numéro de publication : **0 011 534**
**B1**

(12) # FASCICULE DE BREVET EUROPÉEN

(45) Date de publication du fascicule du brevet :
09.06.82

(51) Int. Cl.³ : **G 06 K 9/38**, G 06 K 7/10,
**H 03 K 5/08**

(21) Numéro de dépôt : **79400793.0**

(22) Date de dépôt : **24.10.79**

(54) **Procédé et dispositif de traitement d'un signal analogique, notamment pseudopériodique.**

(30) Priorité : **25.10.78 FR 7830399**

(43) Date de publication de la demande :
**28.05.80 (Bulletin 80/11)**

(45) Mention de la délivrance du brevet :
**09.06.82 Bulletin 82/23**

(84) Etats contractants désignés :
**DE GB IT NL**

(56) Documents cités :
**US A 3 344 284**
**US A 3 838 448**
**US A 3 909 594**
**US A 4 012 715**

(73) Titulaire : **COMPAGNIE INTERNATIONALE POUR L'INFORMATIQUE CII - HONEYWELL BULL (dite CII-HB)**
**94, avenue Gambetta**
**F-75020 Paris (FR)**

(72) Inventeur : **Maussion, Daniel**
**Saint-Lambert-La-Potherie**
**F-49000 Angers (FR)**

(74) Mandataire : **Davroux, Yves**
**94, Avenue Gambetta**
**F-75020 Paris (FR)**

Imprimerie Jouve, 18, rue St-Denis, 75001 Paris, France

Procédé et dispositif de traitement d'un signal analogique, notamment pseudopériodique

L'invention concerne le traitement d'un signal analogique pseudopériodique. Ce traitement est indiqué lorsque ledit signal analogique est destiné à être converti en une succession d'impulsions à fronts raides, par un circuit de commutation à seuil, en vue de son exploitation par un système de traitement logique.

On rencontre fréquemment en électronique le problème de la conversion d'un signal analogique, périodique ou pseudopériodique, en des impulsions à fronts raides et d'amplitude constante. Par exemple, on peut rencontrer le cas où il est nécessaire de générer un train d'impulsions à partir du signal analogique, chaque impulsion étant engendrée en réponse et en synchronisme avec une alternance positive (ou négative) considérée comme significative, du signal analogique. On sait cependant qu'avec un moyen de conversion analogique-numérique du type mentionné plus haut, c'est-à-dire utilisant un circuit de commutation à seuil, une impulsion engendrée à partir d'alternances dites « significatives » aura une durée d'autant plus longue que l'amplitude de ladite alternance significative correspondante sera plus élevée. Si cette amplitude est trop faible, l'impulsion correspondante peut avoir une durée trop courte pour pouvoir être « reconnue » et comptabilisée par un système de logique numérique ; ou même, elle peut ne pas être engendrée si la valeur de crête de ladite alternance est inférieure à la valeur de seuil du circuit de commutation à seuil susmentionné.

A titre d'exemple plus spécifique, on connaît certains dispositifs de lecture d'informations (lecteurs de chèques utilisés par les banques) fonctionnant par détection du passage de bâtonnets d'encre magnétisée devant une tête de lecture à magnétorésistance. Un tel dispositif de lecture est décrit en particulier dans la demande de brevet européen n° 10.495 publiée le 30 avril 1980. Le signal analogique élémentaire délivré par une magnétorésistance en réponse au passage d'un bâtonnet isolé est constitué de, successivement, une alternance négative de faible amplitude, une alternance positive de forte amplitude et une alternance négative de faible amplitude ; l'énergie électrique correspondant à l'alternance positive étant égale à la somme des énergies électriques correspondant aux deux alternances négatives. L'alternance positive est donc considérée comme « alternance significative » puisqu'on a une unique alternance positive par bâtonnet. Une succession rapprochée de plusieurs bâtonnets se traduit, au niveau de la magnétorésistance de lecture, par un signal analogique pseudopériodique résultant de la somme des réponses individuelles du type décrit ci-dessus. Dans ce signal pseudopériodique, chaque alternance positive est significative. On pourrait donc se contenter, en principe, d'appliquer ce signal analogique à un circuit de commutation à seuil, à travers une simple diode, pour obtenir le train d'impulsions utilisable par le système de logique numérique. Cependant, l'amplitude de chaque bâtonnet peut varier dans des limites assez larges dans le signal pseudopériodique car les bâtonnets (notamment sur un chèque) n'ont pas forcément la même hauteur ni la même rémanence. Le cas le plus défavorable est celui où un signal élémentaire de forte amplitude est engendré aussitôt après un signal élémentaire de faible amplitude. Dans ce cas, la première alternance négative du signal élémentaire de forte amplitude se « retranche » de l'alternance positive significative du signal élémentaire de faible amplitude et l'impulsion à fronts raides engendrée à partir de cette alternance positive amoindrie est alors d'une durée très brève ou même parfois totalement inexistante.

L'invention, telle qu'elle est caractérisée dans les revendications, permet entre autre de supprimer ce genre d'inconvénient. L'idée de base de l'invention consiste à modifier le signal analogique de façon à augmenter l'amplitude des alternances significatives.

Une technique voisine est connue du brevet des Etats-Unis d'Amérique n° 3.344.284 qui décrit un circuit écrêteur de signal vidéo intermodulé visant à soustraire une tension image de l'enveloppe négative du signal composite audit signal pour écrêter les valeurs de pics du signal dépassant une tension significative de l'excursion maximale crête à crête désirée du signal et correspondant typiquement au niveau de blanc du signal vidéo.

L'invention concerne donc un procédé de traitement d'un signal analogique, notamment pseudopériodique, comportant des alternances significatives inférieures et supérieures à un niveau de référence prédéterminé, ce signal analogique étant la combinaison de signaux élémentaires successifs, éventuellement partiellement superposés, correspondant chacun à une marque magnétique discrète et constitué chacun par une succession d'alternances élémentaires négative-positive-négative par rapport à un niveau de base inférieur au niveau de référence, et dont l'alternance élémentaire positive centrale constitue ladite alternance significative, consistant, en vue de faciliter la correction de la conversion du signal analogique en une succession d'impulsions à front raide, à générer une tension continue variable dont la variation est représentative de la valeur moyenne ou de la valeur de crête des alternances négatives du signal analogique ; et à ajouter algébriquement à un signal proportionnel audit signal analogique une tension proportionnelle à ladite tension continue variable mais inverse de celle-ci par rapport audit niveau de base.

Autrement dit, le procédé énoncé ci-dessus permet de combiner le signal analogique à l'enveloppe des alternances d'un type donné (en l'occurrence les alternances négatives, dans le cas mentionné ci-dessus) dans le but de rendre significatives les excursions crête-à-crête du signal pseudopériodique au lieu des simples alternances positives de ce dernier.

L'invention concerne également un dispositif de traitement de signal analogique pour la mise en œuvre de ce procédé, et comprenant : d'une part, un moyen générateur de tension continue variable comportant une entrée pour recevoir ledit signal analogique et une sortie de tension continue variable, d'autre part, un moyen sommateur de tension à deux entrées, dont l'une est connectée pour recevoir le signal analogique et dont l'autre est reliée à la sortie du moyen générateur de tension continue variable, ce moyen générateur de tension continue variable comportant un dispositif suiveur de tension de crête comprenant : un premier amplificateur différentiel, dont l'entrée inverseuse est reliée à l'entrée du moyen générateur de tension, par exemple au moyen d'une liaison capacitive, et dont l'entrée non inverseuse reçoit une tension continue stable de référence ; un condensateur dont une électrode est à un potentiel de référence ; une diode connectée entre la sortie du premier amplificateur différentiel et l'autre électrode du condensateur, afin de charger ce dernier ; et un circuit de décharge du condensateur, ce circuit définissant avec le condensateur une constante de temps choisie.

L'invention sera mieux comprise, et d'autres buts, détails et avantages de celle-ci apparaîtront mieux à la lumière de la description explicative qui va suivre d'un procédé et d'un dispositif conformes au principe de l'invention, donnée uniquement à titre d'exemple et faite en référence aux dessins non limitatifs annexés, dans lesquels :

Les figures 1a à 1d représentent un chronogramme illustrant la formation d'un signal pseudopériodique à partir de deux signaux élémentaires et les impulsions à fronts raidés obtenues à partir de ce signal lorsqu'il est appliqué à un circuit de commutation à seuil ;

Les figures 2a à 2c illustrent le procédé de l'invention appliqué au signal pseudopériodique de la figure 1c ; et

La figure 3 est un schéma de principe d'un système électronique de traitement de signal analogique, selon l'invention.

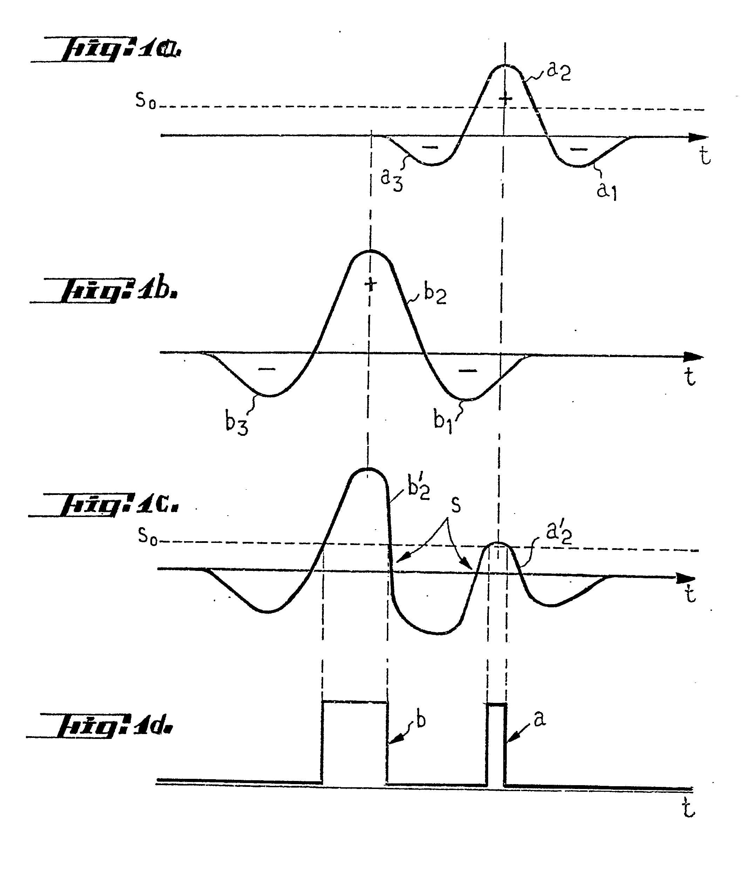

La figure 1a montre le signal analogique élémentaire délivré par une tête de lecture à magnétorésistance, en réponse au passage d'un bâtonnet imprimé par une encre magnétisée. Ce signal analogique élémentaire est formé successivement d'une alternance négative $a_1$, d'une alternance positive $a_2$ et d'une alternance négative $a_3$. Comme mentionnée précédemment, l'énergie de l'alternance $a_2$ est égale à la somme des énergies des alternances $a_1$ et $a_3$. Par ailleurs, puisqu'on désire identifier le passage d'un bâtonnet, on considérera tout naturellement l'alternance $a_2$ comme « significative » puisque cette alternance est de plus grande amplitude que les deux autres et, surtout, qu'elle est unique.

A première vue, il suffirait donc de disposer d'un circuit de commutation à seuil, réglé sur le seuil $S_0$, pour obtenir une impulsion à fronts raides, pour chaque alternance $a_2$. Cependant, on notera que le signal élémentaire représenté sur la figure 1a est de relativement faible niveau. Autrement dit, les valeurs de crête des alternances $a_1$, $a_2$ et $a_3$, sont relativement faibles. Comme mentionnés précédemment, tous les signaux élémentaires correspondant aux différents bâtonnets n'ont pas le même niveau. La figure 1b représente au contraire un autre signal analogique élémentaire (d'alternance $b_1$, $b_2$, $b_3$ successives) correspondant à un bâtonnet dont le champ magnétique est plus intense et qui suit immédiatement l'autre bâtonnet ayant provoqué le signal analogique élémentaire de la figure 1a. On voit qu'une partie de l'alternance $b_1$ est engendrée en même temps que l'alternance significative $a_2$. Comme ces deux alternances sont de signes contraires, la tête de lecture délivrera en fait un signal analogique pseudopériodique S représenté sur la figure $a'_2$ (qui correspond à l'alternance $a_2$) et sera considérablement atténuée par rapport à sa valeur prévue, illustrée sur la figure 1a, et ceci à cause de l'alternance négative $b_1$. Le résultat néfaste de ce « chevauchement » des réponses individuelles de faible et forte amplitude est illustré par la figure 1d qui représente les impulsions résultantes, à la sortie d'un circuit de commutation à seuil (réglé sur le seuil $S_0$) qui recevrait à son entrée le signal pseudopériodique de la figure 1c. On voit que la durée de l'impulsion a (provenant de l'alternance significative amoindrie $a'_2$) est très courte, comparée notamment à la durée de l'impulsion b issue de l'alternance significative $b'_2$. On comprend même que si la situation est encore un peu plus défavorable (c'est-à-dire lorsque la valeur de crête de l'alternance $a'_2$ devient inférieure à la valeur du seuil $S_0$) l'impulsion a peut être totalement absente, ce qui crée une erreur de lecture.

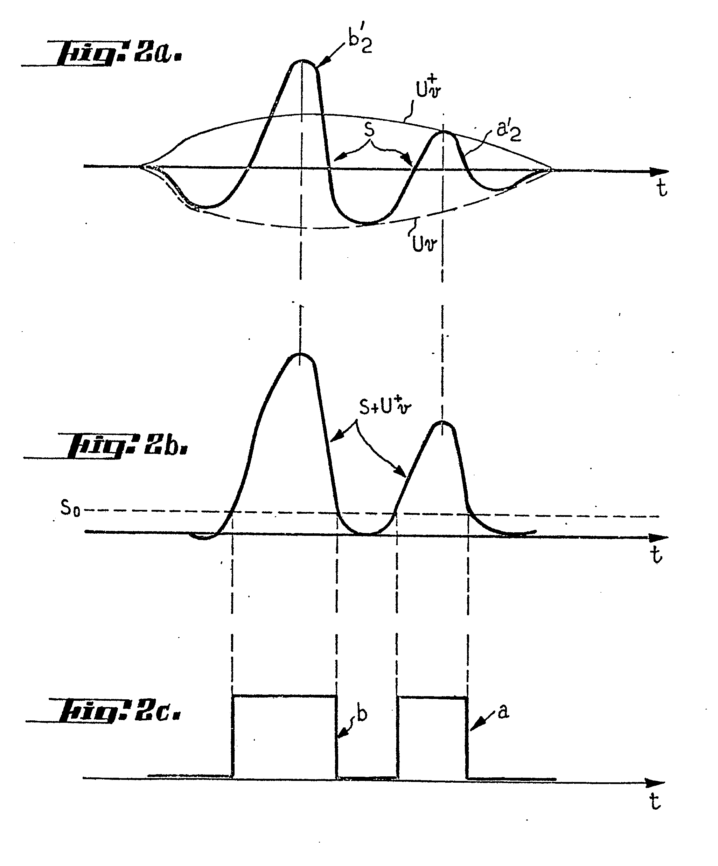

Les figures 2a à 2c illustrent les conséquences de l'application du procédé énoncé ci-dessus au signal analogique pseudopériodique de la figure 1c. On commence par générer une tension continue variable $U_v$ dont la variation est sensiblement représentative de l'évolution de la valeur de crête (il pourrait aussi s'agir de la valeur moyenne) des alternances négatives du signal analogique S. Cette tension négative constitue donc en quelque sorte l'enveloppe des alternances négatives du signal S. Il est facile, par des moyens électroniques classiques, à partir de cette tension $U_v$ de générer une tension $U_v^+$ proportionnelle à la tension $U_v$ et, dans l'exemple représenté, de signe opposé et d'ajouter algébriquement cette tension proportionnelle $U_v^+$ au signal analogique S lui-même, pour obtenir le signal analogique représenté sur la figure 2b. Si ce dernier signal est appliqué à l'entrée d'un circuit de commutation à seuil, réglé sur le même seuil $S_0$ que précédemment, les impulsions résultantes seront conformes à la figure 2c où l'on voit que la durée de ces impulsions a été très sensi-

blement augmentée, en particulier en ce qui concerne l'impulsion *a*. Il est à noter que dans l'exemple précédent on a parlé d'alternances positives et négatives parce que le niveau de référence mentionné plus haut a été choisi à un potentiel nul, mais il est parfaitement envisageable que ce niveau de référence soit lui-même une tension non nulle positive ou négative. Il sera toujours possible d'engendrer une tension $U_v$ représentant la valeur moyenne ou la valeur de crête des alternances inférieures (ou supérieures) au niveau de référence et de générer à partir de cette tension $U_v$, une autre tension $U_v^+$ de loi de variation inverse à celle de la tension $U_v$, par rapport au niveau de référence.

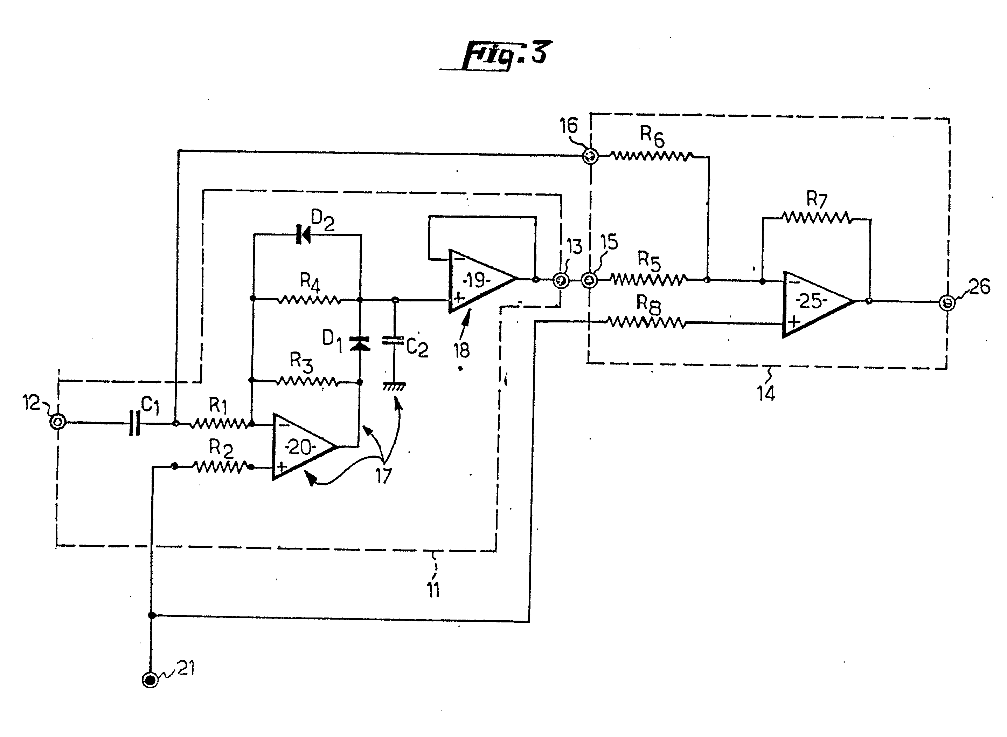

On va maintenant décrire, en référence à la figure 3, un système électronique susceptible de mettre en œuvre le procédé décrit ci-dessus.

Le montage se compose essentiellement d'un moyen générateur de tension continue variable 11 comportant une entrée 12 recevant le signal analogique pseudopériodique de la figure 1c et une sortie 13 de tension continue variable, ainsi que d'un moyen sommateur de tension 14 à deux entrées 15 et 16. L'entrée 15 est reliée à la sortie 13.

Le moyen générateur de tension continue variable se compose essentiellement d'un dispositif suiveur de tension de crête 17 connecté pour recevoir le signal analogique S appliqué à l'entrée 12. Ce dispositif suiveur est complété par un étage de liaison formé d'un simple amplificateur 18 dont la sortie coïncide avec la sortie 13. Dans l'exemple décrit, l'amplificateur est constitué d'un amplificateur différentiel 19 à très grand gain en boucle ouverte mais dont la sortie est directement connectée à son entrée inverseuse pour former un amplificateur de gain unité ; l'entrée non inverseuse recevant le signal en provenance dudit dispositif suiveur 17. Ce dernier comporte un premier amplificateur différentiel 20 dont l'entrée inverseuse est reliée à l'entrée 12 par l'intermédiaire d'une connexion en série d'une résistance $R_1$ et d'un condensateur $C_1$ et dont l'entrée non inverseuse reçoit une tension continue stable de référence, appliquée à la borne 21, par l'intermédiaire d'une résistance $R_2$. Cette tension continue stable concrétise en fait le niveau de référence prédéterminé précité puisqu'elle permet de déterminer la tension de repos de l'amplificateur 20. Cette transposition du point de fonctionnement de l'amplificateur (et de tout le système) autour d'une tension positive donnée, est avantageuse car elle permet d'éviter d'avoir à alimenter l'amplificateur différentiel à partir de deux sources de tension, l'une positive et l'autre négative. Grâce à cette transposition en tension, une seule tension d'alimentation, positive, est nécessaire. Un circuit de contre-réaction est branché entre la sortie de l'amplificateur différentiel 20 et son entrée inverseuse. Ce circuit de contre-réaction comprend une résistance $R_3$ branchée en parallèle avec une résistance $R_4$ et une diode $D_1$ connectées en série. Une autre diode $D_2$ dont le rôle sera expliqué plus loin peut également être montée en parallèle sur la résistance $R_4$, sa cathode étant reliée à l'entrée inverseuse de l'amplificateur différentiel 20. L'anode de la diode $D_1$ est quant à elle reliée à la sortie de ce même amplificateur différentiel et son anode à un condensateur $C_2$ et à l'entrée de l'amplificateur 19. L'autre borne du condensateur $C_2$ est connectée à un potentiel de référence, par exemple la terre. Les résistances $R_3$ et $R_4$ (et aussi la diode $D_2$) font partie d'un circuit de décharge du condensateur $C_2$ alors que la diode $D_1$ fait plutôt partie, avec l'amplificateur 20, d'un circuit de charge de ce même condensateur. La constante de temps du circuit de décharge (donc dans une certaine mesure la valeur du condensateur $C_2$) est choisie en fonction de la fréquence moyenne du signal pseudopériodique, de sorte que le condensateur $C_2$ puisse se maintenir chargé à une valeur voisine de la tension de crête des alternances du signal de sortie de l'amplificateur 20 qui lui sont transmises par la diode $D_1$.

Le moyen sommateur de tension se compose quant à lui d'un second amplificateur différentiel 25. Les deux entrées 15 et 16 précitées sont reliées à l'entrée inverseuse de cet amplificateur 25, par l'intermédiaire de résistances respectives $R_5$, $R_6$. Une résistance $R_7$ est connectée entre la sortie de l'amplificateur différentiel 25 (qui est aussi la sortie 26 du système) et son entrée inverseuse. L'amplificateur différentiel 25 ayant un gain en boucle ouverte très important, on reconnaît donc bien là un montage classique de circuit sommateur de tensions. Par ailleurs, l'entrée non inverseuse de l'amplificateur différentiel 25 est reliée à la borne 21 par l'intermédiaire d'une résistance $R_8$, pour assurer comme précédemment le décalage du point de fonctionnement de cet amplificateur. L'entrée 16 est reliée au pont commun de $C_1$ et $R_1$.

La diode $D_2$ pourrait être remplacée par un autre élément à caractéristique non linéaire, pourvu qu'il permette, au moins à partir d'un certain seuil, de limiter progressivement la charge du condensateur $C_2$, pour au moins les plus grandes amplitudes du signal analogique.

Le fonctionnement du dispositif qui vient d'être décrit découle avec évidence de ce qui précède. Comme le signal analogique appliqué à l'entrée 12 parvient à l'entrée inverseuse de l'amplificateur différentiel 20, ce sont les variations des alternances négatives dudit signal qui parviennent par l'intermédiaire de la diode $D_1$ au condensateur $C_2$ et le chargent à une tension continue variable représentative de l'évolution des tensions de crête des alternances négatives du signal d'entrée.

On notera donc que l'amplificateur différentiel 20 réalise en fait « l'inversion » du signal analogique lui-même ce qui permet d'obtenir directement (grâce à la diode $D_1$ et au condensateur $C_2$) la tension continue variable $U_v^+$ illustrée sur la figure 2a. Ceci montre qu'un grand nombre de circuits électroniques peuvent être aisément imaginés pour engendrer les tensions $U_v$ et/ou $U_v^+$ sans sortir du cadre de l'invention. La tension aux

bornes du condensateur $C_2$ étant sensiblement la tension $U_v^+$, celle-ci se retrouve donc appliquée à l'entrée 15 du moyen formant sommateur de tension 14, par l'intermédiaire de l'amplificateur 19. Cette tension $U_v^+$ se trouve donc additionnée au signal d'entrée qui se trouve appliqué à l'entrée 16 par l'intermédiaire du condensateur $C_1$. Le signal analogique disponible à la sortie 26 est donc bien conforme à ce qui est représenté sur la figure 2b, avec simplement une inversion du sens de variation, ce qui ne présente aucune espèce d'inconvénient pour l'exploitation de ce signal de sortie.

Bien entendu, l'invention n'est nullement limitée au mode de réalisation du dispositif qui vient d'être décrit. En particulier, la valeur du condensateur $C_2$ et les caractéristiques de son circuit de décharge pourraient être modifiées pour que la tension continue variable présente à ses bornes soit représentative de la valeur moyenne des alternances négatives du signal d'entrée. C'est dire que l'invention comprend tous les équivalents techniques des moyens mis en jeu si ceux-ci le sont dans le cadre des revendications qui suivent.

**Revendications**

1. Procédé de traitement d'un signal analogique (S) notamment pseudopériodique, comportant des alternances significatives inférieures $(a'_2)$ et supérieures $(b'_2)$ à un niveau de référence prédéterminé $(S_0)$, ce signal analogique étant la combinaison de signaux élémentaires successifs, éventuellement partiellement superposés, correspondant chacun à une marque magnétique discrète et constitué chacun par une succession d'alternances élémentaires négative-positive-négative par rapport à un niveau de base (B) inférieur au niveau de référence $(S_0)$, dont l'alternance élémentaire positive centrale constitue ladite alternance significative, caractérisé en ce qu'il consiste, en vue de faciliter la correction de la conversion du signal analogique (S) en une succession d'impulsions à front raide (a ; b) :
— à générer une tension continue variable $(U_v)$ dont la variation est représentative de la valeur moyenne ou de la valeur de crête des alternances négatives du signal analogique (S) ; et
— à ajouter algébriquement à un signal proportionnel audit signal analogique (S) une tension $(U_v^+)$ proportionnelle à ladite tension continue variable mais inverse de celle-ci par rapport audit niveau de base (B).

2. Procédé selon la revendication 1, caractérisé en ce qu'il comprend l'étape de réduire les maxima de ladite tension proportionnelle correspondant aux plus grandes amplitudes négatives dudit signal analogique (S).

3. Dispositif de traitement de signal analogique pour la mise en œuvre du procédé selon la revendication 1, caractérisé en ce qu'il comprend : d'une part, un moyen (11) générateur de tension continue variable $(U_v)$ comportant une entrée (12) pour recevoir ledit signal analogique (S) et une sortie de tension continue variable (13), d'autre part, un moyen sommateur de tension (14) à deux entrées, dont l'une (16) est connectée pour recevoir le signal analogique (S) et dont l'autre (15) est reliée à la sortie (13) du moyen générateur de tension continue variable (11), ce moyen générateur de tension continue variable comportant un dispositif suiveur de tension de crête (17) comprenant :
— un premier amplificateur différentiel (20) dont l'entrée inverseuse est reliée à l'entrée (12) du moyen générateur de tension (11), par exemple au moyen d'une liaison capacitive $(C_1)$ et dont l'entrée non inverseuse reçoit une tension continue stable de référence ;
— un condensateur $(C_2)$ dont une électrode est à un potentiel de référence ;
— une diode $(D_1)$ connectée entre la sortie du premier amplificateur différentiel (20) et l'autre électrode du condensateur $(C_2)$ afin de charger ce dernier ; et
— un circuit de décharge $(R_3, R_4, D_2)$ du condensateur $(C_2)$, ce circuit définissant avec le condensateur une constante de temps choisie.

4. Dispositif selon la revendication 3, caractérisé en ce que le moyen générateur de tension continue variable (11) comporte en outre un étage de liaison (18) tel qu'un amplificateur (19), par exemple de gain unité, l'entrée de cet amplificateur étant reliée au condensateur $(C_2)$ du dispositif suiveur de tension de crête (17).

5. Dispositif selon l'une des revendications 3 et 4, caractérisé en ce que le moyen sommateur de tension (14) est constitué d'un second amplificateur différentiel (25), dont l'entrée inverseuse est reliée aux entrées (15, 16) du moyen sommateur de tension par l'intermédiaire de résistances respectives $(R_5, R_6)$, et dont l'entrée non inverseuse reçoit la tension continue stable de référence.

6. Dispositif selon l'une des revendications 3 à 5, caractérisé en ce que le circuit de décharge comporte un élément à caractéristique non linéaire, tel que par exemple une diode $(D_2)$ pour limiter la charge du condensateur $(C_2)$ pour au moins les plus grandes amplitudes négatives du signal analogique (S).

**Claims**

1. Method of processing an analog signal (S) in particular a pseudoperiodic signal, comprising significant alternations which are lower $(a'_2)$ and higher $(b'_2)$ than a predetermined reference level $(S_0)$, this analog signal being the combination of successive elementary signals which may be partially superposed, each corresponding to a discrete magnetic symbol and each formed by a succession of elementary alternations which are negative-positive-negative with respect to a base level (B) lower than the reference level $(S_0)$ of which the positive central elementary alternation forms the said significant alternation, characterised in that for the purpose of facilitating the correction of the conversion of the analog signal (S) into a succession of steep-fronted pulses (a ; b), said method consists :

— in generating a variable direct voltage ($U_v$) of which the variation represents the mean value or the peak value of the negative alternations of the analog signal (S) ; and

— in algebraically adding to a signal proportional to the said analog signal (S), a voltage ($U_v^+$) proportional to the said variable direct voltage but the inverse of the latter with respect to the said base level (B).

2. Method according to claim 1, characterised in that it comprises a stages for reducing the maximum values of the said proportional voltage corresponding to the greatest negative amplitudes of the said analog signal (S).

3. Analog signal processing device for carrying out the method according to claim 1, characterised in that it comprises : on the one hand, a means (11) for generating a variable direct voltage ($U_v$) comprising an input (12) for reception of said analog signal (S) and an output (13) for a variable direct voltage, and on the other hand a voltage summator means (14) comprising two inputs of which one (16) is connected to receive the analog signal (S) and the other (15) is connected to the output (13) of the means (11) for generating a variable direct voltage, said variable direct voltage generating means comprising a peak voltage follower device (17) comprising :

— a first differential amplifier (20) of which the inverting input is connected to the input (12) of the voltage generating means (11), for example by means of a capacitive connection ($C_1$) and of which the noninverting input receives a stable direct reference voltage ;

— a capacitor ($C_2$) of which one electrode is at a reference potential ;

— a diode ($D_1$) connected between the output of the first differential amplifier (20) and the other electrode of the capacitor ($C_2$) for the purpose of charging the latter ; and

— a circuit ($R_3$, $R_4$, $D_2$) for discharging the capacitor ($C_2$), this circuit defining a selected time constant with the capacitor.

4. Device according to claim 3, characterised in that the means (11) for generating a variable direct voltage further comprise a coupling stage (18) such as an amplifier (19), for example having unity gain, the input of this amplifier being connected to the capacitor ($C_2$) of the peak value follower device (17).

5. Device according to either of claims 3 and 4, characterised in that the voltage summator means (14) comprise a second differential amplifier (25) of which the inverting input is connected to the inputs (15, 16) of the voltage summator means via respective resistors ($R_5$, $R_6$), and of which the non-inverting input receives the stable direct reference voltage.

6. Device according to any one of claims 3 to 5, characterised in that the discharge circuit comprises an element having a non-linear characteristic, such as a diode ($D_2$), for limiting the charge of the capacitor ($C_2$) for at least the maximum negative amplitudes of the analog signal (S).

**Ansprüche**

1. Verfahren zur Verarbeitung eines insbesondere pseudoperiodischen Analogsignals (S), das bedeutsame Teilperioden aufweist, die unterhalb ($a_2'$) bzw. oberhalb ($b_2'$) eines vorbestimmten Bezugspegels ($S_0$) liegen, wobei dieses Analogsignal die Kombination von aufeinanderfolgenden Elementarsignalen ist, die teilweise überlagert sein können und jeweils einer diskreten magnetischen Markierung entsprechen und jeweils aus einer Aufeinanderfolge von elementaren Teilperioden negativ-positiv-negativ in bezug auf einen Basispegel (B), der niedriger ist als der Bezugspegel ($S_0$), gebildet sind, wovon die positive mittlere elementare Teilperiode die bedeutsame Teilperiode bildet, dadurch gekennzeichnet, daß es zur Erleichterung der Korrektur der Umsetzung des Analogsignals (S) in eine Folge von Impulsen mit steiler Flanke (a ; b) darin besteht, daß :

— eine variable Gleichspannung ($U_v$) erzeugt wird, deren Änderung den Mittelwert oder den Spitzenwert der negativen Teilperioden des Analogsignals (S) darstellt ; und

— daß zu einem dem Analogsignal (S) proportionalen Signal algebraisch eine Spannung ($U_v^+$) hinzugefügt wird, die proportional der genannten variablen Gleichspannung ist, jedoch in bezug auf den Basispegel (B) gegenüber dieser invertiert ist.

2. Verfahren nach Anspruch 1, dadurch gekennzeichnet, daß es den Schritt umfaßt, daß die Maxima der proportionalen Spannung reduziert werden, welche den größten negativen Amplituden des Analogsignals (S) entsprechen.

3. Vorrichtung zur Verarbeitung eines Analogsignals zur Durchführung des Verfahrens nach Anspruch 1, dadurch gekennzeichnet, daß sie enthält : zum einen eine Einrichtung (11) zur Erzeugung einer variablen Gleichspannung ($U_v$), welche einen Eingang (12) zum Empfangen des Analogsignals (S) und einen Ausgang (13) zur Abgabe einer variablen Gleichspannung umfaßt, und zum anderen eine Spannungssummiereinrichtung (14) mit zwei Eingängen, von denen der eine (16) so angeschlossen ist, daß er das Analogsignal (S) empfängt, und der andere (15) an den Ausgang (13) der Einrichtung (11) zur Erzeugung der variablen Gleichspannung angeschlossen ist, wobei diese Einrichtung zur Erzeugung der variablen Gleichspannung eine Spitzenspannungswert-Nachfolgevorrichtung (17) umfaßt, die enthält :

— einen ersten Differentialverstärker (20), dessen invertierender Eingang mit dem Eingang (12) der Spannungserzeugereinrichtung (11) verbunden ist, z.B. mittels einer kapazitiven Verbindung ($C_1$), und dessen nicht invertierender Eingang eine stabile Bezugsgleichspannung

empfängt ;

— einen Kondensator (C$_2$), dessen eine Elektrode auf einem Bezugspotential liegt ;

— eine Diode (D$_1$), die zwischen den Ausgang des ersten Differentialverstärkers (20) und die andere Elektrode des Kondensators (C$_2$) geschaltet ist, um diesen aufzuladen ; und

— eine Entladeschaltung (R$_3$, R$_4$, D$_2$) zum Entladen des Kondensators (C$_2$), wobei diese Schaltung mit dem Kondensator eine gewählte Zeitkonstante definiert.

4. Vorrichtung nach Anspruch 3, dadurch gekennzeichnet, daß die Einrichtung (11) zur Erzeugung der variablen Gleichspannung ferner eine Verbindungsstufe (18) wie einen Verstärker (19), z.B. mit der Verstärkung 1, umfaßt, wobei der Eingang dieses Verstärkers mit dem Kondensator (C$_2$) der Spitzenspannungswert-Nachfolgevor-

richtung (17) verbunden ist.

5. Vorrichtung nach einem der Ansprüche 3 und 4, dadurch gekennzeichnet, daß die Spannungssummiereinrichtung (14) aus einem zweiten Differentialverstärker (25) gebildet ist, dessen invertierender Eingang mit den Eingängen (15, 16) der Spannungssummiereinrichtung über je einen Widerstand (R$_5$, R$_6$) verbunden ist und dessen nicht invertierender Eingang die stabile Bezugsgleichspannung empfängt.

6. Vorrichtung nach einem der Ansprüche 3 bis 5, dadurch gekennzeichnet, daß die Entladeschaltung ein Element mit nicht linearer Charakteristik umfaßt, z.B. eine Diode (D$_2$), um die Ladung des Kondensators (C$_2$) für wenigstens die größten negativen Amplituden des Analogsignals (S) zu begrenzen.

Fig. 1a.

Fig. 1b.

Fig. 1c.

Fig. 1d.

Fig. 2a.

Fig. 2b.

Fig. 2c.

2

_Fig. 3_

0011 534